# EUROPEAN PATENT APPLICATION

(11) **EP 4 685 653 A1**
(43) Date of publication of application: **28.01.2026**
(21) Application number: 25186258.7
(22) Date of filing: 30.06.2025
(51) Int. Cl.: G06F 11/30, G06F 11/34

(54) **APPARATUSES, METHODS, AND COMPUTER PROGRAM PRODUCTS FOR ANOMALY DETECTION**

(30) Priority: 26.07.2024 US 202418786059
(71) Applicant: Vocollect, Inc., Pittsburgh, Pennsylvania 15235 (US)
(72) Inventor: RACER, Jesse, Charlotte, 28202 (US); VAZQUEZ SEN, Edgar, Charlotte, 28202 (US); DE JESUS GONZALEZ NORIEGA, Luis, Charlotte, 28202 (US)
(74) Representative: Haseltine Lake Kempner LLP

(57) **Abstract**

Methods, apparatuses, and computer program products for anomaly detection are provided. For example, a computer-implemented method includes receiving data corresponding to a plurality of metrics from a plurality of devices, inputting at least a first portion of the received data covering a first time period into a data model to train the data model, inputting at least a second portion of the received data covering a second time period into the trained data model, identifying from the data model one or more anomalies corresponding to one or more of the plurality of metrics of one or more of the plurality of devices, determining if a predefined filter exists for the one or more of the plurality of metrics corresponding to each of the one or more anomalies identified, and applying the predefined filter to determine if the corresponding identified anomaly will be recorded as a reportable anomaly.

## Description

### TECHNOLOGICAL FIELD

Example embodiments of the present disclosure relate generally to anomaly detection and, more particularly, to methods, apparatuses, and computer program products for using a data model for anomaly detection.

### BACKGROUND

Many industrial, retail, and other types of facilities/applications have embraced technology to improve operations, including the use of mobile computing devices, printers, and scanners. Such devices provide a large amount of data related to operations. Such devices also provide data related to status, performance, etc. of the devices themselves.

The data from the devices can be analyzed to identify problems, potential problems, inefficiencies, etc., as indicated for example by outlying data points, which may be collectively termed anomalies, with the devices.

Applicant has discovered problems with current implementations of anomaly detection systems and methods. Through applied effort, ingenuity, and innovation, many of these identified problems have been solved by developing solutions that are included in embodiments of the present disclosure, many examples of which are described in detail herein.

### BRIEF SUMMARY

Various embodiments described herein relate to methods, apparatuses, and computer program products for anomaly detection.

In accordance with various embodiments of the present disclosure, a computer-implemented method is provided. In some embodiments, a computer-implemented method comprises receiving data corresponding to a plurality of metrics from a plurality of devices; inputting at least a first portion of the received data covering a first time period into a data model to train the data model; inputting at least a second portion of the received data covering a second time period into the trained data model, the second time period being less than the first time period; identifying from the data model one or more anomalies corresponding to one or more of the plurality of metrics of one or more of the plurality of devices; determining if a predefined filter exists for the one or more of the plurality of metrics corresponding to each of the one or more anomalies identified; and if it is determined that a predefined filter exists for one or more of the plurality of metrics corresponding to one or more anomalies identified, applying the predefined filter to the one or more of the plurality of metrics for which a predefined filter exists to determine if the corresponding identified anomaly will be recorded as a reportable anomaly.

In some embodiments, the plurality of devices comprises one or more mobile computing devices, one or more printers, and/or one or more scanners.

In some embodiments, at least some of the plurality of metrics correspond to battery temperature, battery discharge, and/or battery recharging cycles.

In some embodiments, the data corresponding to the plurality of metrics from the plurality of devices is repeatedly received.

In some embodiments, the first time period spans from a date of most recently received data back a predefined number of days.

In some embodiments, the method further comprises, for each of one or more of the plurality of metrics for which the received data is cumulative, calculating a delta value between a most recently received data value and an immediately precedingly received data value.

In some embodiments, applying the predefined filter to the one or more of the plurality of metrics for which a predefined filter exists comprises comparing a data value of each of the one or more of the plurality of metrics for which a predefined filter exists to a corresponding predefined threshold value.

In accordance with various embodiments of the present disclosure, an apparatus is provided. In some embodiments, the apparatus comprises at least one processor and at least one non-transitory memory comprising program code. The at least one non-transitory memory and the program code are configured to, with the at least one processor, cause the apparatus to at least receive data corresponding to a plurality of metrics from a plurality of devices; input at least a first portion of the received data covering a first time period into a data model to train the data model; input at least a second portion of the received data covering a second time period into the trained data model, the second time period being less than the first time period; identify from the data model one or more anomalies corresponding to one or more of the plurality of metrics of one or more of the plurality of devices; determine if a predefined filter exists for the one or more of the plurality of metrics corresponding to each of the one or more anomalies identified; and if it is determined that a predefined filter exists for one or more of the plurality of metrics corresponding to one or more anomalies identified, apply the predefined filter to the one or more of the plurality of metrics for which a predefined filter exists to determine if the corresponding identified anomaly will be recorded as a reportable anomaly.

In accordance with various embodiments of the present disclosure, a computer program product is provided. In some embodiments, the computer program product comprises at least one non-transitory computer-readable storage medium having computer-readable program code portions stored therein. The computer-readable program code portions comprising an executable portion configured to: receive data corresponding to a plurality of metrics from a plurality of devices; input at least a first portion of the received data covering a first time period into a data model to train the data model; input at least a second portion of the received data covering a second time period into the trained data model, the second time period being less than the first time period; identify from the data model one or more anomalies corresponding to one or more of the plurality of metrics of one or more of the plurality of devices; determine if a predefined filter exists for the one or more of the plurality of metrics corresponding to each of the one or more anomalies identified; and if it is determined that a predefined filter exists for one or more of the plurality of metrics corresponding to one or more anomalies identified, apply the predefined filter to the one or more of the plurality of metrics for which a predefined filter exists to determine if the corresponding identified anomaly will be recorded as a reportable anomaly.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

Having thus described the embodiments of the disclosure in general terms, reference now will be made to the accompanying drawings, which are not necessarily drawn to scale, and wherein:
FIG. 1 illustrates a block diagram of a system for anomaly detection that may be specially configured within which embodiments of the present disclosure may operate;
FIG. 2 illustrates a block diagram of an example user device that may be specially configured in accordance with an example embodiment of the present disclosure;
FIG. 3 illustrates a block diagram of an example anomaly monitoring device that may be specially configured in accordance with an example embodiment of the present disclosure;
FIG. 4 illustrates a flowchart including operational blocks of an example process for training a data model for anomaly detection, in accordance with at least some example embodiments of the present disclosure; and
FIG. 5 illustrates a flowchart including operational blocks of an example process for anomaly detection using a trained data model, in accordance with at least some example embodiments of the present disclosure.

### DETAILED DESCRIPTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," "bottom," "left," "right," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The phrases "in one example," "according to one example," in some examples," and the like generally mean that the particular feature, structure, or characteristic following the phrase may be included in at least one example of the present disclosure and may be included in more than one example of the present disclosure (importantly, such phrases do not necessarily refer to the same example).

Any reference to claim elements in the singular, for example, using the articles "a," "an" or "the," is not to be construed as limiting the element to the singular and may, in some instances, be construed in the plural.

If the specification states a component or feature "may," "can," "could," "should," "would," "preferably," "possibly," "typically," "optionally," "for example," "as an example," "in some examples," "often," or "might" (or other such language) be included or have a characteristic, that specific component or feature is not required to be included or to have the characteristic. Such component or feature may be optionally included in some examples, or it may be excluded.

The word "example" or "exemplary" is used herein to mean "serving as an example, instance, or illustration." Any implementation described herein as "example" or "exemplary" is not necessarily to be construed as preferred or advantageous over other implementations.

Various embodiments of the present disclosure overcome the above technical challenges and difficulties and provide various technical improvements and advantages. Embodiments of the present disclosure provide for detecting anomalies in each of a plurality of devices. In various embodiments, such devices include, but are not limited to, mobile computing devices (e.g., laptops, tablets, smartphones), printers, scanners, and the like. In various embodiments, such anomalies include, but are not limited to, problems, potential problems, inefficiencies, etc., related to each device. In various embodiments, such anomalies correspond to one or more of a plurality of metrics being tracked for some or all of the devices. In various embodiments, such metrics may correspond to any measurable attribute of a device. For example, such metrics may correspond to one or more battery performance indicators, such as battery cycle count (i.e., number of charge/discharge cycles), battery temperature, and/or battery discharge rate (i.e., the rate at which the battery charge is decreasing, typically measured in percent per hour).

In various embodiments, the metric data from a plurality of devices is received repeatedly, for example, once daily. In various embodiments, the metric data is used to train a data model. In various embodiments, any suitable data model may be used, such as an Isolation Forest data model. In various embodiments, each time new metric data is received (e.g., each day), the data model training is updated with the new metric data. In various embodiments, only the metric data from a predefined most recent time period (e.g., the past 30 days) is used to train the data model. In various embodiments, the received data is separated into data for each metric before being provided to the data model for training the data model.

In various embodiments, the metric data from a plurality of devices belonging to a plurality of different organizations may be received, used to train a data model, and analyzed by a trained data model to identify anomalies in any one or more of the devices. Such organizations may be, for example, different companies, different divisions within companies, different locations within companies or divisions of companies, etc. In various embodiments, the received data is segregated by organization before it is used to train a data model.

In various embodiments, some of the metric data is cumulative. That is, some of the metric data values build on the previous time period's data value. For example, battery cycle data is typically a representation of the total number of battery cycles over the battery's lifetime. In various embodiments, such cumulative data is converted to incremental or delta data by subtracting the immediately preceding metric data value from the most recent metric data value. In various embodiments, it is this converted incremental or delta data value that is used to train a data model and is analyzed by a trained data model.

In various embodiments, metric data received covering a most recent time period (e.g., the prior day's data if data is received daily) is provided to a trained data model to identify one or more anomalies in one or more of the metrics. In various embodiments, the received data is segregated by organization before it is analyzed by a trained data model. In various embodiments, the received data is separated into data for each metric before being provided to the trained data model for analysis and identification of anomalies.

In various embodiments, one or more predetermined filters may be provided for one or more of the metrics. In various embodiments, the filters may be applied to anomalies detected by the trained data model to determine if the anomalous values are nonetheless acceptable (e.g., within an acceptable range). In various embodiments, a filter may specify, for example, an upper threshold value below which an anomalous value is still considered acceptable, a lower threshold above which an anomalous value is still considered acceptable, or a range within which an anomalous value is still considered acceptable. In various embodiments, a filter may use predetermined default values or values specific to an organization (e.g., company, division, location, etc.). In various embodiments, an anomalous value that is determined by a filter to be nonetheless acceptable is not recorded as a reportable anomaly.

The anomaly detection systems and methods of embodiments of the invention are able to scale quickly and enable users to quickly identify issues with their devices and take action to resolve them.

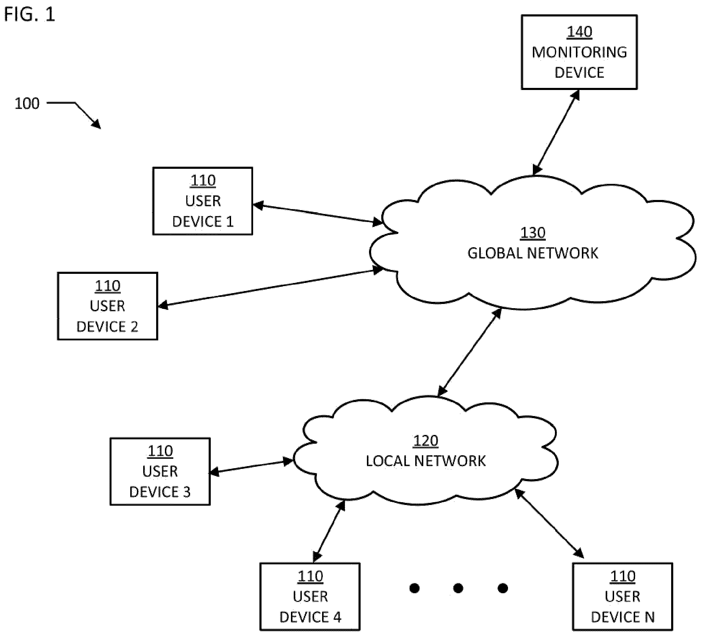

Referring now to the figures, FIG. 1 is an example block diagram of an example system for anomaly detection in accordance with example embodiments of the present disclosure. FIG. 1 illustrates an example anomaly detection system that repeatedly receives data from a potentially large number of user devices, uses the data to train and continually update the training of a data model, and provides the data to a trained data model to detect anomalies in any one or more of the user devices. As described above, such user devices include, but are not limited to, mobile computing devices (e.g., laptops, tablets, smartphones), printers, scanners, and the like, and, such anomalies include, but are not limited to, problems, potential problems, inefficiencies, etc., related to each device.

In the illustrated embodiment, the anomaly detection system 100 comprises a plurality of user devices 110 in communication with a monitoring device 140 over one or more networks. In the example embodiment, some of the user devices 110 are in communication with the monitoring device 140 directly via a global network 130 (e.g., the internet), while some of the user devices 110 are in communication with the monitoring device 140 indirectly via an intermediate local network 120 and a global network 130. The intermediate local network 120 may be, for example, an organization's intranet. In example embodiments, any suitable number of user devices 110 may be monitored. In the illustrated embodiment, the user devices 110 are labeled 1 to N to indicate the potentially varying number of user devices.

In various embodiments, such a monitoring device 140 may be an organization-specific device and receive metric data from a large number of user devices used by that single organization. In various other embodiments, such a monitoring device 140 may be provided by a third party and may receive metric data from a large number of user devices from a plurality of different organizations.

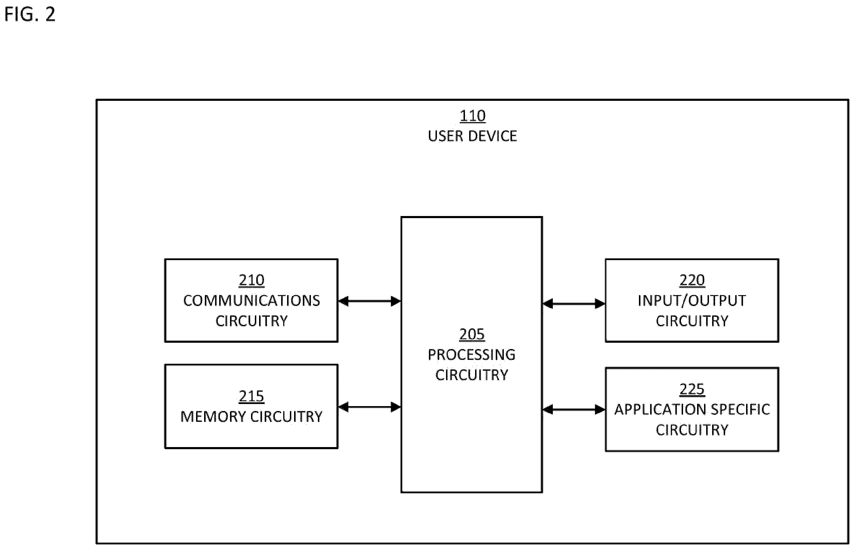

FIG. 2 is an example block diagram of an example user device 110 in accordance with example embodiments of the present disclosure. In the illustrated embodiment, the user device 110 comprises processing circuitry 205, communications circuitry 210, memory circuitry 215, input/output circuitry 220, and application specific circuity 225. The application specific circuitry may comprise, for example, printing circuitry and/or scanning circuitry.

In an example embodiment, the processing circuitry 205 controls the operation of the user device 110 and its various components, typically according to configuration data and instructional programming stored in the memory circuitry 215. In an example embodiment, the communications circuitry 210 enables the user device 110 to communicate with the monitoring device 140 to transmit the metric data, such as via the network 120 or the network 130. In an example embodiment, the input/output circuitry 220 enables a user to interface with the user device 110, such as to provide inputs and/or view outputs.

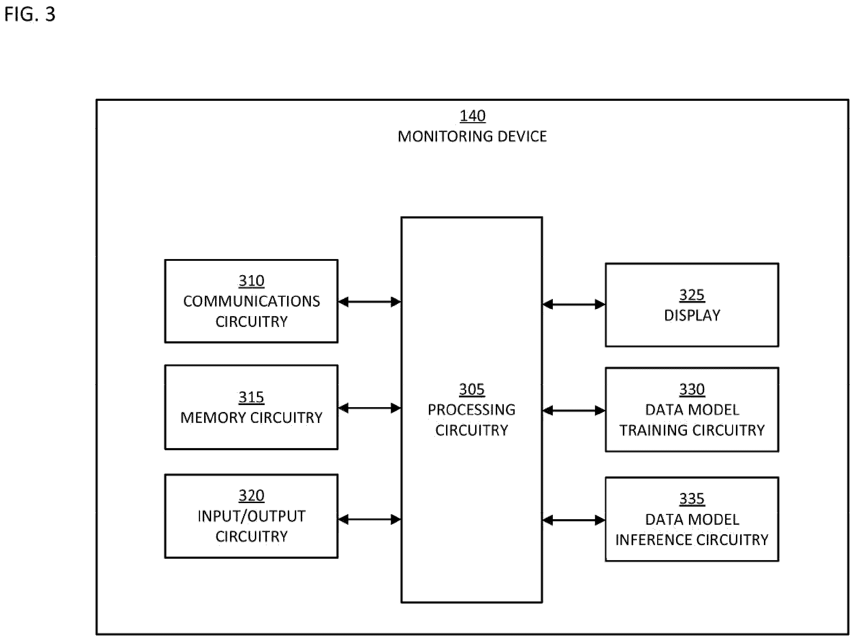

FIG. 3 is an example block diagram of an example monitoring device for anomaly detection in accordance with example embodiments of the present disclosure. The example monitoring device 140 of FIG. 3 communicates with the user devices 110 to receive the metric data, such as via the network 120 or the network 130. In the illustrated embodiment, the monitoring device 140 comprises processing circuitry 305, communications circuitry 310, memory circuitry 315, input/output circuitry 320, a display 325, data model training circuitry 330, and data model inference circuitry 335.

In an example embodiment, the processing circuitry 305 controls the operation of the monitoring device 140 and its various components, typically according to configuration data and instructional programming stored in the memory circuitry 315. In an example embodiment, the communications circuitry 310 enables the monitoring device 140 to communicate with the user devices 110 to receive metric data, such as via the network 120 or the network 130. In an example embodiment, the input/output circuitry 320 enables a user to interface with the monitoring device 140, such as to provide inputs and/or view outputs.

In an example embodiment, the processing circuitry 305 inputs the data for each metric (typically segregated by organization) into the data model training circuitry 330. In an example embodiment, the data model training circuitry 330 uses the metric data to train a data model to identify anomalies in the data related to one or more metrics. In a specific example embodiment, the data model training circuitry 330 uses the metric data to train an Isolation Forest data model.

In an example embodiment, the processing circuitry 305 inputs each new batch (e.g., data received in the past 24 hours) of the data received for each metric (typically segregated by organization) into the data model inference circuitry 335. In an example, embodiment, the data model inference circuitry 335 applies the trained data model to identify anomalies in the data related to one or more metrics.

In an example embodiment, the processing circuitry 305 applies one or more filters to the identified anomalies. In an example embodiment, the processing circuitry 305 displays the identified anomalies, such as via display 325, or otherwise provides information regarding the identified anomalies to the appropriate organization/user. In various examples of the present disclosure, the display 325 may include a liquid crystal display (LCD), a light-emitting diode (LED) display, a plasma (PDP) display, a quantum dot (QLED) display, and/or the like.

The user devices 110 and the monitoring device 140 may be configured to execute the operations described herein. Although the components are described with respect to functional limitations, it should be understood that the particular implementations necessarily include the use of particular hardware. It should also be understood that certain of the components described herein may include similar or common hardware. For example, two sets of circuitries may both leverage use of the same processor, network interface, storage medium, or the like to perform their associated functions, such that duplicate hardware is not required for each set of circuitries.

The use of the term "circuitry" as used herein with respect to components of the apparatuses should therefore be understood to include particular hardware configured to perform the functions associated with the particular circuitry as described herein. The term "circuitry" should be understood broadly to include hardware and, in some embodiments, software for configuring the hardware. For example, in some embodiments, "circuitry" may include processing circuitry, storage media, network interfaces, input/output devices, and the like. In some embodiments, other elements of the anomaly detection system 100 may provide or supplement the functionality of particular circuitry. For example, the processing circuitry 205, 305 may provide processing functionality, the communications circuitry 210, 310 may provide network interface functionality, the memory circuitry 215, 315 may provide storage functionality, and the like.

In some embodiments, the processing circuitry 205, 305 (and/or co-processor or any other processing circuitry assisting or otherwise associated with the processor) may be in communication with, respectively, the memory circuitry 215, 315 via a bus for passing information among components of the apparatus. The processing circuitry 205, 305 may be embodied in a number of different ways and may, for example, include one or more processing devices configured to perform independently. Additionally, or alternatively, the processing circuitry 205, 305 may include one or more processors configured in tandem via a bus to enable independent execution of instructions, pipelining, and/or multithreading. The use of the term "processing circuitry" may be understood to include a single core processor, a multi-core processor, multiple processors internal to the apparatus, and/or remote or "cloud" processors.

For example, the processing circuitry 205, 305 may be embodied as one or more complex programmable logic devices (CPLDs), microprocessors, multi-core processors, co-processing entities, application-specific instruction-set processors (ASIPs), and/or controllers. Further, the processing circuitry 205, 305 may be embodied as one or more other processing devices or circuitry. The term circuitry may refer to an entirely hardware embodiment or a combination of hardware and computer program products. Thus, the processing circuitry 205, 305 may be embodied as integrated circuits, application specific integrated circuits (ASICs), field programmable gate arrays (FPGAs), programmable logic arrays (PLAs), hardware accelerators, other circuitry, and/or the like. As will therefore be understood, the processing circuitry 205, 305 may be configured for a particular use or configured to execute instructions stored in volatile or non-volatile media or otherwise accessible to the processing circuitry 205, 305. As such, whether configured by hardware or computer program products, or by a combination thereof, the processing circuitry 205, 305 may be capable of performing steps or operations according to embodiments of the present disclosure when configured accordingly.

In an example embodiment, the processing circuitry 205, 305 may be configured to execute instructions stored, respectively, in the memory circuitry 215, 315 or otherwise accessible to the processor. Alternatively, or additionally, the processing circuitry 205, 305 may be configured to execute hard-coded functionality. As such, whether configured by hardware or software methods, or by a combination thereof, the processor may represent an entity (e.g., physically embodied in circuitry) capable of performing operations according to an embodiment of the present disclosure while configured accordingly. Alternatively, as another example, when the processing circuitry 205, 305 is embodied as an executor of software instructions, the instructions may specifically configure the processor to perform the algorithms and/or operations described herein when the instructions are executed.

In some embodiments, the memory circuitry 215, 315 may further include or be in communication with volatile media (also referred to as volatile storage, memory, memory storage, memory circuitry and/or similar terms used herein interchangeably). In some embodiments, the volatile storage or memory may also include, such as but not limited to, RAM, DRAM, SRAM, FPM DRAM, EDO DRAM, SDRAM, DDR SDRAM, DDR2 SDRAM, DDR3 SDRAM, RDRAM, RIMM, DIMM, SIMM, VRAM, cache memory, register memory, and/or the like. As will be recognized, the memory circuitry 215, 315 may be used to store at least portions of the databases, database instances, database management system entities, data, applications, programs, program modules, scripts, source code, object code, byte code, compiled code, interpreted code, machine code, executable instructions, and/or the like being executed by, respectively, for example, the processing circuitry 205, 305 as shown in FIGS. 2 and 3. Thus, the databases, database instances, database management system entities, data, applications, programs, program modules, scripts, source code, object code, byte code, compiled code, interpreted code, machine code, executable instructions, and/or the like may be used to control certain aspects of the operation of the user devices 110 and/or the monitoring device 140 with the assistance of, respectively, the processing circuitry 205, 305 and operating system.

In some embodiments, the memory circuitry 215, 315 may further include or be in communication with non-volatile media (also referred to as non-volatile storage, memory, memory storage, memory circuitry and/or similar terms used herein interchangeably). In some embodiments, the memory circuitry 215, 315 may include, such as, but not limited to, hard disks, ROM, PROM, EPROM, EEPROM, flash memory, MMCs, SD memory cards, Memory Sticks, CBRAM, PRAM, FeRAM, RRAM, SONOS, racetrack memory, and/or the like. As will be recognized, the memory circuitry 215, 315 may store databases, database instances, database management system entities, data, applications, programs, program modules, scripts, source code, object code, byte code, compiled code, interpreted code, machine code, executable instructions, and/or the like. The term database, database instance, database management system entity, and/or similar terms used herein interchangeably and in a general sense to may refer to a structured or unstructured collection of information/data that is stored in a computer-readable storage medium.

In various embodiments of the present disclosure, the memory circuitry 215, 315 may also be embodied as a data storage device or devices, as a separate database server or servers, or as a combination of data storage devices and separate database servers. Further, in some embodiments, memory circuitry 215, 315 may be embodied as a distributed repository such that some of the stored information/data is stored centrally in a location within the system and other information/data is stored in one or more remote locations. Alternatively, in some embodiments, the distributed repository may be distributed over a plurality of remote storage locations only. An example of the embodiments contemplated herein would include a cloud data storage system maintained by a third-party provider and where some or all of the information/data required for the operation of the recovery system may be stored. Further, the information/data required for the operation of the recovery system may also be partially stored in the cloud data storage system and partially stored in a locally maintained data storage system. More specifically, memory circuitry 215, 315 may encompass one or more data stores configured to store information/data usable in certain embodiments.

In the example as shown in FIGS. 2 and 3, one or more instances of circuitry may be part of the memory circuitry 215, 315. In this example, the term "circuitry" refers to one or more data storage units in the memory circuitry 215, 315 that may store executable computer program instructions. When the executable computer program instructions stored in such circuitry are executed by a processing circuitry (such as, but not limited to, the processing circuitry 205, 305 shown in FIGS. 2 and 3), the executable computer program instructions may cause the processing circuitry to perform one or more functions.

The communications circuitry 210, 310 may be any means such as a device or circuitry embodied in either hardware or a combination of hardware and software that is configured to receive and/or transmit data from/to a network and/or any other device, circuitry, or module in communication with, respectively, the user devices 110 and/or the monitoring device 140. In this regard, the communications circuitry 210, 310 may include, for example, a network interface for enabling communications with a wired or wireless communication network and/or in accordance with a variety of networking protocols described herein. For example, the communications circuitry 210, 310 may include one or more network interface cards, antennae, buses, switches, routers, modems, and supporting hardware and/or software, or any other device suitable for enabling communications via a network. Additionally, or alternatively, the communication interface may include the circuitry for interacting with the antenna(s) to cause transmission of signals via the antenna(s) or to handle receipt of signals received via the antenna(s).

It is also noted that all or some of the information discussed herein can be based on data that is received, generated and/or maintained by one or more components of the user devices 110 and/or the monitoring device 140. In some embodiments, one or more external systems (such as a remote cloud computing and/or data storage system) may also be leveraged to provide at least some of the functionality discussed herein.

The communications networks 120, 130 may embody any of a myriad of network(s) configured to enable communication between two or more computing device(s). In some embodiments, the communications network 120 embodies a private network. For example, the monitoring device 140 may be embodied by various computing device(s) on an internal network, such as one or more server(s) of a facility in communication with the various user devices 110 positioned at various locations in the facility. In some embodiments, the communications network 130 embodies a public network, for example the Internet. In some such embodiments, the monitoring device 140 may embody a remote or "cloud" system that accesses the user devices 110 over the communications network 130 from a location separate from the physical location of the user devices 110. For example, the monitoring device 140 may be embodied by computing device(s) of a central headquarters, central monitoring facility, server farm, distributed platform, and/or the like. In some such embodiments, the monitoring device 140 may be accessed directly (e.g., via a display and/or peripherals operatively engaged with the monitoring device 140), and/or may be accessed indirectly through use of a client device. For example, in some embodiments, a user may login (e.g., utilizing a username and password) or otherwise access the monitoring device 140 to access the described functionality with respect to one or more particular facilities.

In some embodiments, the input/output circuitry 220, 320 may be in communication with, respectively, the processing circuitry 205, 305 to provide output to the user and, in some embodiments, to receive an indication of a user input. The input/output circuitry 220, 320 may include a keyboard, a mouse, a joystick, a touch screen, touch areas, soft keys, a microphone, a speaker, or other input/output mechanisms. The processor and/or user interface circuitry comprising the processor may be configured to control one or more functions of one or more user interface elements through computer program instructions (e.g., software and/or firmware) stored on a memory accessible to the processor (e.g., the memory circuitry 215, 315, and/or the like).

The methods, apparatuses, systems, and computer program products of the present disclosure may be embodied by any variety of devices. For example, a method, apparatus, system, and computer program product of an example embodiment may be embodied by a fixed computing device, such as a personal computer, computing server, computing workstation, or a combination thereof. Further, an example embodiment may be embodied by any of a variety of mobile terminals, mobile telephones, smartphones, laptop computers, tablet computers, or any combination of the aforementioned devices.

Having described example systems, apparatuses, computing environments, and user interfaces associated with embodiments of the present disclosure, example flowcharts including various operations performed by the apparatuses and/or systems described herein will now be discussed. It should be appreciated that each of the flowcharts depicts an example computer-implemented process that may be performed by one or more of the apparatuses, systems, and/or devices described herein, for example utilizing one or more of the components thereof. The blocks indicating operations of each process may be arranged in any of a number of ways, as depicted and described herein. In some such embodiments, one or more blocks of any of the processes described herein occur in-between one or more blocks of another process, before one or more blocks of another process, and/or otherwise operates as a sub-process of a second process. Additionally or alternative, any of the processes may include some or all of the steps described and/or depicted, including one or more optional operational blocks in some embodiments. In regard to the below flowcharts, one or more of the depicted blocks may be optional in some, or all, embodiments of the disclosure. Optional blocks are depicted with broken (or "dashed") lines. Similarly, it should be appreciated that one or more of the operations of each flowchart may be combinable, replaceable, and/or otherwise altered as described herein.

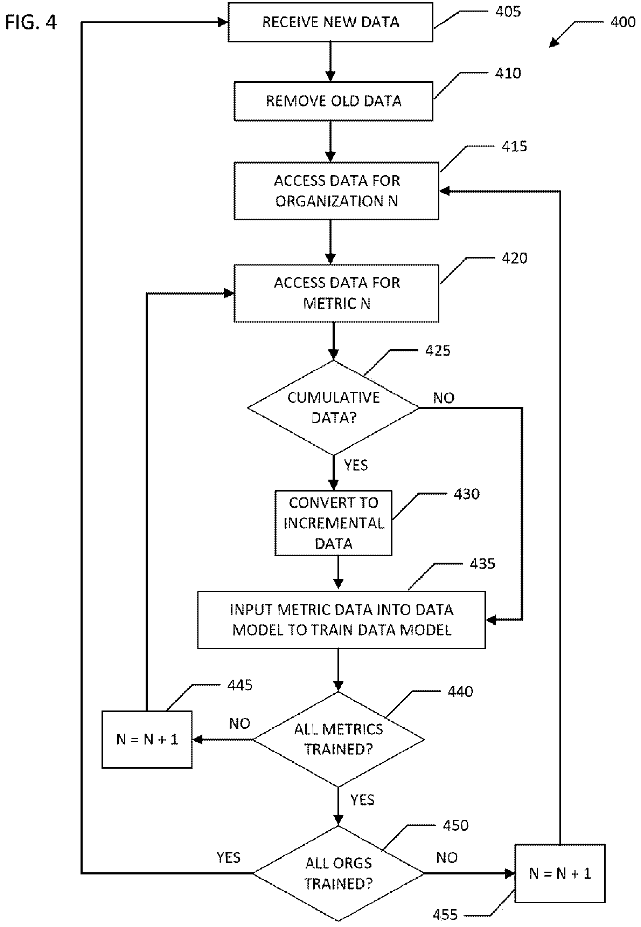

FIG. 4 illustrates a flowchart including operational blocks of an example process for training a data model for anomaly detection, in accordance with at least some example embodiments of the present disclosure. Specifically, FIG. 4 depicts operations of an example process 400. In some embodiments, the computer-implemented process 400 is embodied by computer program code stored on a non-transitory computer-readable medium of a computer program product configured for execution to perform the computer-implemented method. Alternatively or additionally, in some embodiments, the example process 400 is performed by one or more specially configured computing devices, such as the monitoring device 140. In this regard, in some such embodiments, the monitoring device 140 is specially configured by computer program instructions stored thereon, for example in the memory circuitry 315 and/or another component depicted and/or described herein, and/or otherwise accessible to the monitoring device 140, for performing the operations as depicted and described with respect to the example process 400. In some embodiments, the specially configured monitoring device 140 includes and/or otherwise is in communication with one or more external apparatuses, systems, devices, and/or the like, to perform one or more of the operations as depicted and described.

The process 400 begins at step/operation 405. At step/operation 405, a processor (such as, but not limited to, the processing circuitry 305 of the monitoring device 140 described above in connection with FIG. 3) receives data related to a plurality of metrics from a plurality of user devices. In some embodiments, the data is received once a day, however, the data may be received on any suitable schedule. In some embodiments, the data may be received on different schedules for different organizations. In various embodiments, the received data is stored in a database along with previously received data.

At step/operation 410, a processor (such as, but not limited to, the processing circuitry 305 of the monitoring device 140 described above in connection with FIG. 3) removes data from the previously received, stored data that is no longer within a predefined window of time. For example, in some embodiments, previously received, stored data that is older than thirty days is removed. In some embodiments, this old data may be deleted or may simply be flagged in the database so that this old data is no longer used to train/update a data model.

At step/operation 415, a processor (such as, but not limited to, the processing circuitry 305 of the monitoring device 140 described above in connection with FIG. 3) accesses the data for a first one of the organizations from which data is received ("organization N"). In some embodiments, this is enabled by comparing the data to a predefined table of participating organizations.

At step/operation 420, a processor (such as, but not limited to, the processing circuitry 305 of the monitoring device 140 described above in connection with FIG. 3) accesses the data for a first one of the metrics ("metric N") from the data from organization N.

At step/operation 425, a processor (such as, but not limited to, the processing circuitry 305 of the monitoring device 140 described above in connection with FIG. 3) determines if the data for metric N is cumulative data. In some embodiments, this is enabled by comparing the metric to a predefined table of metrics and their properties.

If it is determined at step/operation 425 that that the data for metric N is not cumulative data, the process 400 proceeds to step/operation 435. If it is determined at step/operation 425 that that the data for metric N is cumulative data, the process 400 proceeds to step/operation 430. At step/operation 430, a processor (such as, but not limited to, the processing circuitry 305 of the monitoring device 140 described above in connection with FIG. 3) converts the cumulative data to incremental or delta data by subtracting the immediately preceding metric data value from the most recent metric data value.

At step/operation 435, a processor (such as, but not limited to, the processing circuitry 305 of the monitoring device 140 described above in connection with FIG. 3) inputs the metric data into a data model to train the data model. In various embodiments, the data model is not trained only one time, but is repeatedly trained (i.e., the training is updated) as new data is repeatedly received.

At step/operation 440, a processor (such as, but not limited to, the processing circuitry 305 of the monitoring device 140 described above in connection with FIG. 3) determines if the data model has been trained for all metrics for organization N. If it is determined at step/operation 440 that the data model has not been trained for all metrics for organization N, the process 400 proceeds to step/operation 445. At step/operation 445, a processor (such as, but not limited to, the processing circuitry 305 of the monitoring device 140 described above in connection with FIG. 3) updates the metric from metric N to metric N+1 and then repeats steps/operations 420-440. If it is determined at step/operation 440 that the data model has been trained for all metrics for organization N, the process 400 proceeds to step/operation 450.

At step/operation 450, a processor (such as, but not limited to, the processing circuitry 305 of the monitoring device 140 described above in connection with FIG. 3) determines if the data model has been trained for all organizations. If it is determined at step/operation 450 that the data model has not been trained for all organizations, the process 400 proceeds to step/operation 455. At step/operation 455, a processor (such as, but not limited to, the processing circuitry 305 of the monitoring device 140 described above in connection with FIG. 3) updates the organization from organization N to organization N+1 and then repeats steps/operations 415-450.

If it is determined at step/operation 450 that the data model has been trained for all organizations, the process 400 returns to step/operation 405 to await the receipt of new data. In various embodiments, the process 400 repeats every time new data is received.

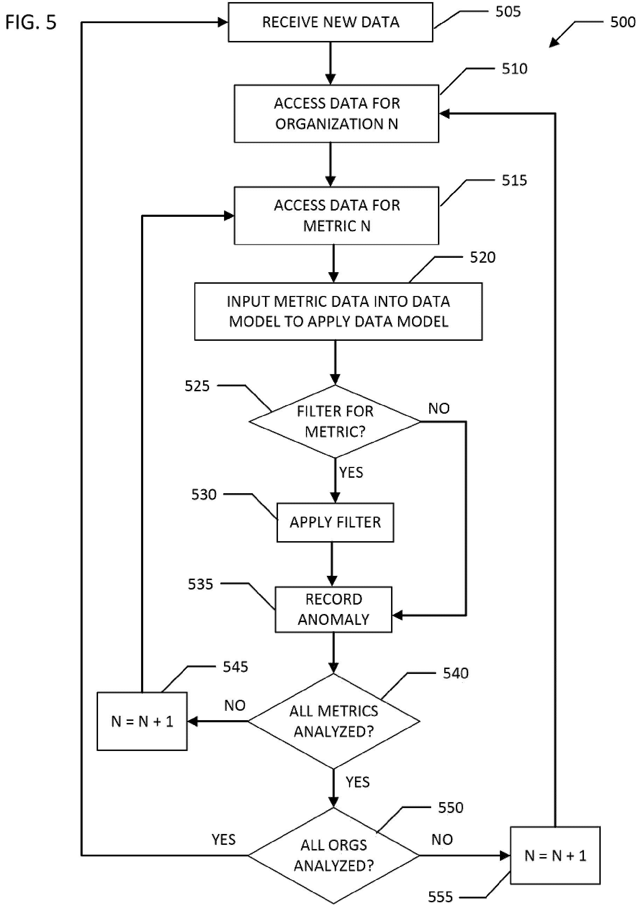

FIG. 5 illustrates a flowchart including operational blocks of an example process for identifying one or more anomalies using a trained data model, in accordance with at least some example embodiments of the present disclosure. Specifically, FIG. 5 depicts operations of an example process 500. In some embodiments, the computer-implemented process 500 is embodied by computer program code stored on a non-transitory computer-readable medium of a computer program product configured for execution to perform the computer-implemented method. Alternatively or additionally, in some embodiments, the example process 500 is performed by one or more specially configured computing devices, such as the monitoring device 140. In this regard, in some such embodiments, the monitoring device 140 is specially configured by computer program instructions stored thereon, for example in the memory circuitry 315 and/or another component depicted and/or described herein, and/or otherwise accessible to the monitoring device 140, for performing the operations as depicted and described with respect to the example process 500. In some embodiments, the specially configured monitoring device 140 includes and/or otherwise is in communication with one or more external apparatuses, systems, devices, and/or the like, to perform one or more of the operations as depicted and described.

The process 500 begins at step/operation 505. At step/operation 505, a processor (such as, but not limited to, the processing circuitry 305 of the monitoring device 140 described above in connection with FIG. 3) receives data related to a plurality of metrics from a plurality of user devices. In some embodiments, the data is received once a day, however, the data may be received on any suitable schedule. In some embodiments, the data may be received on different schedules for different organizations. In various embodiments, the received data is stored in a database along with previously received data. In various embodiments, this receipt of data is the same receipt of data occurring at step/operation 405 of process 400 of FIG. 4.

At step/operation 510, a processor (such as, but not limited to, the processing circuitry 305 of the monitoring device 140 described above in connection with FIG. 3) accesses the data for a first one of the organizations from which data is received ("organization N"). In some embodiments, this is enabled by comparing the data to a predefined table of participating organizations. In various embodiments, this data access is different than the data access occurring at step/operation 415 of process 400 of FIG. 4, as the data accessed at step/operation 510 of process 500 of FIG. 5 typically only includes the most recently received batch of data.

At step/operation 515, a processor (such as, but not limited to, the processing circuitry 305 of the monitoring device 140 described above in connection with FIG. 3) accesses the data for a first one of the metrics ("metric N") from the data from organization N. In various embodiments, this data access is different than the data access occurring at step/operation 420 of process 400 of FIG. 4, as the data accessed at step/operation 515 of process 500 of FIG. 5 typically only includes the most recently received batch of data.

At step/operation 520, a processor (such as, but not limited to, the processing circuitry 305 of the monitoring device 140 described above in connection with FIG. 3) inputs the metric data into a trained data model (such as a data model trained using the steps/operations of process 400 described in FIG. 4) to detect one or more anomalies in the metric data.

At step/operation 525, a processor (such as, but not limited to, the processing circuitry 305 of the monitoring device 140 described above in connection with FIG. 3) determines if the metric provided to the trained data model at step/operation 520 has a predefined filter. As described above, a filter is used to determine if an identified anomaly will be recorded as a reportable anomaly.

If it is determined at step/operation 525 that the metric provided to the trained data model at step/operation 520 does not have a predefined filter, the process 500 proceeds to step/operation 535. If it is determined at step/operation 525 that the metric provided to the trained data model at step/operation 520 does have a predefined filter, the process 500 proceeds to step/operation 530.

At step/operation 530, a processor (such as, but not limited to, the processing circuitry 305 of the monitoring device 140 described above in connection with FIG. 3) applies the predefined filter to the identified anomaly of the metric. In various embodiments, applying a predefined filter typically involves comparing the anomalous value (i.e., the value of the metric data considered by the trained data model to be an anomaly) to a predefined upper threshold value, lower threshold value, or range.

At step/operation 530, a processor (such as, but not limited to, the processing circuitry 305 of the monitoring device 140 described above in connection with FIG. 3) records the one or more anomalies identified at step/operation 520. In various embodiments, any anomalies filtered out at step/operation 530 are not recorded as anomalies. In various embodiments, the recorded anomalies can be reported to one or more users, such as on a display screen.

At step/operation 540, a processor (such as, but not limited to, the processing circuitry 305 of the monitoring device 140 described above in connection with FIG. 3) determines if the data model has been applied for all metrics for organization N. If it is determined at step/operation 540 that the data model has not been applied for all metrics for organization N, the process 500 proceeds to step/operation 545. At step/operation 545, a processor (such as, but not limited to, the processing circuitry 305 of the monitoring device 140 described above in connection with FIG. 3) updates the metric from metric N to metric N+1 and then repeats steps/operations 515-540. If it is determined at step/operation 545 that the data model has been trained for all metrics for organization N, the process 500 proceeds to step/operation 550.

At step/operation 550, a processor (such as, but not limited to, the processing circuitry 305 of the monitoring device 140 described above in connection with FIG. 3) determines if the data model has been applied for all organizations. If it is determined at step/operation 550 that the data model has not been applied for all organizations, the process 500 proceeds to step/operation 555. At step/operation 555, a processor (such as, but not limited to, the processing circuitry 305 of the monitoring device 140 described above in connection with FIG. 3) updates the organization from organization N to organization N+1 and then repeats steps/operations 510-550.

If it is determined at step/operation 550 that the data model has been applied for all organizations, the process 500 returns to step/operation 505 to await the receipt of new data. In various embodiments, the process 500 repeats every time new data is received.

Having described example systems, apparatuses, computing environments, and user interfaces associated with embodiments of the present disclosure, example flowcharts including various operations performed by the apparatuses and/or systems described herein will now be discussed. It should be appreciated that each of the flowcharts depicts an example computer-implemented process that may be performed by one or more of the apparatuses, systems, and/or devices described herein, for example utilizing one or more of the components thereof. The blocks indicating operations of each process may be arranged in any of a number of ways, as depicted and described herein. In some such embodiments, one or more blocks of any of the processes described herein occur in-between one or more blocks of another process, before one or more blocks of another process, and/or otherwise operates as a sun-process of a second process. Additionally or alternative, any of the processes may include some or all of the steps described and/or depicted, including one or more optional operational blocks in some embodiments. In regard to the below flowcharts, one or more of the depicted blocks may be optional in some, or all, embodiments of the disclosure. Optional blocks are depicted with broken (or "dashed") lines. Similarly, it should be appreciated that one or more of the operations of each flowchart may be combinable, replaceable, and/or otherwise altered as described herein.

Although an example processing system has been described above, implementations of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more modules of computer program instructions, encoded on computer storage medium for execution by, or to control the operation of, information/data processing apparatus. Alternatively, or in addition, the program instructions can be encoded on an artificially generated propagated signal, e.g., a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially generated propagated signal. The computer storage medium can also be, or be included in, one or more separate physical components or media (e.g., multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application-specific integrated circuit). The apparatus can also include, in addition to hardware, code that creates an execution environment for the computer program in question, e.g., code that constitutes processor firmware, a protocol stack, a repository management system, an operating system, a cross-platform runtime environment, a virtual machine, or a combination of one or more of them. The apparatus and execution environment can realize various different computing model infrastructures, such as web services, distributed computing, and grid computing infrastructures.

A computer program (also known as a program, software, software application, script, or code) can be written in any form of programming language, including compiled or interpreted languages, declarative or procedural languages, and it can be deployed in any form, including as a stand-alone program or as a module, component, subroutine, object, or other unit suitable for use in a computing environment. A computer program may, but need not, correspond to a file in a file system. A program can be stored in a portion of a file that holds other programs or information/data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communications network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random-access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, e.g., magnetic, magneto-optical disks, or optical disks. However, a computer need not have such devices. Devices suitable for storing computer program instructions and information/data include all forms of non-volatile memory, media, and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, e.g., a CRT (cathode ray tube) or LCD (liquid crystal display) monitor, for displaying information/data to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, e.g., as an information/data server, or that includes a middleware component, e.g., an application server, or that includes a front-end component, e.g., a client computer having a graphical user interface or a web browser through which a user can interact with an implementation of the subject matter described herein, or any combination of one or more such back-end, middleware, or front-end components. The components of the system can be interconnected by any form or medium of digital information/data communication, e.g., a communications network. Examples of communications networks include a local area network ("LAN") and a wide area network ("WAN"), an inter-network (e.g., the Internet), and peer-to-peer networks (e.g., ad hoc peer-to-peer networks).

The computing system can include clients and servers. A client and server are generally remote from each other and typically interact through a communications network. The relationship of client and server arises by virtue of computer programs running on the respective computers and having a client-server relationship to each other. In some embodiments, a server transmits information/data (e.g., an HTML page) to a client device (e.g., for purposes of displaying information/data to and receiving user input from a user interacting with the client device). Information/data generated at the client device (e.g., a result of the user interaction) can be received from the client device at the server.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

## Claims

1. A computer-implemented method, comprising:
receiving data corresponding to a plurality of metrics from a plurality of devices;
inputting at least a first portion of the received data covering a first time period into a data model to train the data model;
inputting at least a second portion of the received data covering a second time period into the trained data model, the second time period being less than the first time period;
identifying from the trained data model one or more anomalies corresponding to one or more of the plurality of metrics of one or more of the plurality of devices;
determining if a predefined filter exists for the one or more of the plurality of metrics corresponding to each of the one or more anomalies identified; and
if it is determined that a predefined filter exists for one or more of the plurality of metrics corresponding to one or more anomalies identified, applying the predefined filter to the one or more of the plurality of metrics for which a predefined filter exists to determine if the corresponding identified anomaly will be recorded as a reportable anomaly.

2. The method of claim 1, wherein the plurality of devices comprises one or more mobile computing devices, one or more printers, and/or one or more scanners.

3. The method of claim 1, wherein at least some of the plurality of metrics correspond to battery temperature, battery discharge, and/or battery recharging cycles.

4. The method of claim 1, wherein the data corresponding to the plurality of metrics from the plurality of devices is repeatedly received.

5. The method of claim 4, wherein the first time period spans from a date of most recently received data back a predefined number of days.

6. The method of claim 4, further comprising:
for each of one or more of the plurality of metrics for which the received data is cumulative, calculating a delta value between a most recently received data value and an immediately precedingly received data value.

7. The method of claim 1, wherein applying the predefined filter to the one or more of the plurality of metrics for which a predefined filter exists comprises comparing a data value of each of the one or more of the plurality of metrics for which a predefined filter exists to a corresponding predefined threshold value.

8. An apparatus comprising at least one processor and at least one non-transitory memory comprising program code, wherein the at least one non-transitory memory and the program code are configured to, with the at least one processor, cause the apparatus to at least:
receive data corresponding to a plurality of metrics from a plurality of devices;
input at least a first portion of the received data covering a first time period into a data model to train the data model;
input at least a second portion of the received data covering a second time period into the trained data model, the second time period being less than the first time period;
identify from the trained data model one or more anomalies corresponding to one or more of the plurality of metrics of one or more of the plurality of devices;
determine if a predefined filter exists for the one or more of the plurality of metrics corresponding to each of the one or more anomalies identified; and
if it is determined that a predefined filter exists for one or more of the plurality of metrics corresponding to one or more anomalies identified, apply the predefined filter to the one or more of the plurality of metrics for which a predefined filter exists to determine if the corresponding identified anomaly will be recorded as a reportable anomaly.

9. The apparatus of claim 8, wherein the plurality of devices comprises one or more mobile computing devices, one or more printers, and/or one or more scanners.

10. The apparatus of claim 8, wherein at least some of the plurality of metrics correspond to battery temperature, battery discharge, and/or battery recharging cycles.

11. The apparatus of claim 8, wherein the data corresponding to the plurality of metrics from the plurality of devices is repeatedly received.

12. The apparatus of claim **11,** wherein the first time period spans from a date of most recently received data back a predefined number of days.

13. The apparatus of claim **11,** wherein the at least one non-transitory memory and the program code are further configured to, with the at least one processor, cause the apparatus to at least:
for each of one or more of the plurality of metrics for which the received data is cumulative, calculating a delta value between a most recently received data value and an immediately precedingly received data value.

14. The apparatus of claim 8, wherein applying the predefined filter to the one or more of the plurality of metrics for which a predefined filter exists comprises comparing a data value of each of the one or more of the plurality of metrics for which a predefined filter exists to a corresponding predefined threshold value.

15. A computer program product comprising at least one non-transitory computer-readable storage medium having computer-readable program code portions stored therein, the computer-readable program code portions comprising an executable portion configured to:
receive data corresponding to a plurality of metrics from a plurality of devices;
input at least a first portion of the received data covering a first time period into a data model to train the data model;
input at least a second portion of the received data covering a second time period into the trained data model, the second time period being less than the first time period;
identify from the trained data model one or more anomalies corresponding to one or more of the plurality of metrics of one or more of the plurality of devices;
determine if a predefined filter exists for the one or more of the plurality of metrics corresponding to each of the one or more anomalies identified; and
if it is determined that a predefined filter exists for one or more of the plurality of metrics corresponding to one or more anomalies identified, apply the predefined filter to the one or more of the plurality of metrics for which a predefined filter exists to determine if the corresponding identified anomaly will be recorded as a reportable anomaly.
